# EUROPEAN PATENT APPLICATION

(11) **EP 4 202 088 A1**
(43) Date of publication of application: **28.06.2023**
(21) Application number: 21857978.7
(22) Date of filing: 08.04.2021
(51) Int. Cl.: C30B 25/18, H01L 21/205, C30B 29/06, C30B 29/38

(54) **METHOD FOR MANUFACTURING NITRIDE SEMICONDUCTOR WAFER, AND NITRIDE SEMICONDUCTOR WAFER**

(30) Priority: 18.08.2020 JP 2020137796
(71) Applicant: Shin-Etsu Handotai Co., Ltd., Tokyo 100-0004 (JP)
(72) Inventor: TSUCHIYA, Keitaro, Annaka-shi, Gunma 379-0196 (JP); SHINOMIYA, Masaru, Annaka-shi, Gunma 379-0196 (JP); HAGIMOTO, Kazunori, Annaka-shi, Gunma 379-0196 (JP); KUBONO, Ippei, Annaka-shi, Gunma 379-0196 (JP)
(74) Representative: Mooser, Sebastian Thomas
(86) International application number: PCT/JP2021/014837
(87) International publication number: WO 2022/038826

(57) **Abstract**

The present invention is a method for producing a nitride semiconductor wafer, in which a nitride semiconductor thin film is grown on a silicon single crystal substrate by vapor phase growth, including, by using a silicon single crystal substrate having a resistivity of 1000 Ω·cm or more, an oxygen concentration of less than 1×10¹⁷ atoms/cm³ and a thickness of 1000 um or more, growing the nitride semiconductor thin film on the silicon single crystal substrate by vapor phase growth. As a result, it is possible to provide a method for producing a nitride semiconductor wafer in which plastic deformation and warpage are suppressed even in the case of a high-resistivity, ultra-low oxygen concentration silicon single crystal substrate, which is promising as a support substrate for high frequency devices, is used.

## Description

### TECHNICAL FIELD

The present invention relates to a method for producing a nitride semiconductor wafer and a nitride semiconductor wafer.

### BACKGROUND ART

Nitride semiconductors such as GaN and AlN are expected to be applied as semiconductor devices for high-frequency applications, since these make the fabrication of high electron mobility transistors (HEMTs) using two-dimensional electron gas possible. In addition, the above-mentioned nitride semiconductor is also a piezoelectric material with excellent mechanical properties, and is expected to be used in high-frequency filters for communication, sensors, energy harvesters, and the like.

### CITATION LIST

### PATENT LITERATURE

Patent Document 1: WO 2005/038899 A1
Patent Document 2: JP 2012-79952 A
Patent Document 3: JP 2011-103380 A

### SUMMARY OF INVENTION

### TECHNICAL PROBLEM

However, it is difficult to produce wafers of these nitride semiconductors. For industrial applications, nitride semiconductor thin films formed by vapor phase growth on sapphire, SiC, and silicon substrates are used. In particular, the production of nitride semiconductor thin film by vapor phase growth on silicon substrates is considered promising because it allows the use of large-diameter substrates compared to sapphire and SiC, resulting in high productivity and an advantage in terms of heat dissipation properties. Patent Document 1 discloses use of a high resistance silicon wafer as a support substrate for a high-frequency communication device.

In addition, in high-frequency devices, in order to improve high-frequency characteristics, it is necessary to reduce parasitic capacitance of the device, its support substrate, and peripheral packages. It is considered that the using of a silicon substrate with a low oxygen concentration and a high resistance as a support substrate or a package for the purpose of the reduction of the parasitic capacity can improve the characteristics and have an advantage in terms of cost.

On the other hand, device manufacturing process includes processes such as epitaxial growth on the substrate, heat treatment, and bonding. There is a risk of plastic deformation resulting from the stress caused in the substrate due to differences in lattice constant and thermal expansion coefficient between different materials. When plastic deformation occurs, the wafer is greatly distorted and cannot return to its original shape. There is a possibility that warpage abnormality or bonding failure may occur.

In particular, a silicon substrate with a high resistivity and a low oxygen concentration has a low mechanical strength because it contains an extremely small amount of impurities such as dopants and oxygen. Therefore, when a nitride semiconductor is epitaxially grown, warpage increases and plastic deformation tend to occur resulting from stress due to difference in lattice constant and thermal expansion coefficient, so stress relaxation is performed by growth conditions and relaxation layers. Patent Document 2 discloses a gallium nitride-based compound semiconductor substrate in which periodic-deposition layers are formed by laminating a plurality of composite layers on a silicon single crystal substrate in order to reduce the warpage of the substrate.

Further, Patent Document 3 discloses a GaN/Si substrate using a silicon substrate with a high resistivity of 5000 Ω·cm, but the amount of warpage increases as the oxygen concentration decreases. However, it is desirable that the amount of warpage is 50 um or less for use in a general device-manufacturing process, and it cannot be said that sufficient countermeasures have been taken.

The present invention has been made to solve the above problems, and the object of the present invention is to provide a method for producing a nitride semiconductor wafer in which plastic deformation and warpage are suppressed even in the case a silicon single crystal substrate with high resistivity and low oxygen concentration, especially ultra-low oxygen concentration, which is promising as a support substrate for high-frequency devices, is used.

### SOLUTION TO PROBLEM

The present invention has been made to achieve the above objects, and provides a method for producing a nitride semiconductor wafer in which a nitride semiconductor thin film is grown on a silicon single crystal substrate by vapor phase growth, comprising, by using a silicon single crystal substrate having a resistivity of 1000 Ω·cm or more, an oxygen concentration of less than 1×10¹⁷ atoms/cm³ and a thickness of 1000 um or more, growing the nitride semiconductor thin film on the silicon single crystal substrate by vapor phase growth.

According to such a method for manufacturing a nitride semiconductor wafer, even when using a silicon single crystal substrate with low mechanical strength, high resistivity, and an ultra-low oxygen concentration of less than 1×10¹⁷ atoms/cm³, a nitride semiconductor wafer in which plastic deformation and warpage are suppressed can be produced.

At this time, after the nitride semiconductor thin film is grown by vapor phase growth, surface of the silicon single crystal substrate opposite to the surface on which the nitride semiconductor thin film is grown is polished to thin the silicon single crystal substrate.

By polishing and thinning the silicon single crystal substrate on the back surface after vapor phase growth in this way, plastic deformation during high-temperature growth can be prevented, and wafers having small warpage can be obtained even if the substrate is processed to a thickness suitable for device manufacturing after cooling.

At this time, it provides a nitride semiconductor wafer having a nitride semiconductor thin film on a silicon single crystal substrate, wherein the silicon single crystal substrate has a resistivity of 1000 Ω·cm or more, an oxygen concentration of less than 1 × 10¹⁷ atoms/cm³, and a thickness of 1000 µm or more.

According to such a nitride semiconductor wafer, it becomes that plastic deformation and warpage are suppressed even when a silicon single crystal substrate having low mechanical strength, high resistivity and ultra-low oxygen concentration is used as the support substrate.

### ADVANTAGEOUS EFFECTS OF INVENTION

As described above, according to the nitride semiconductor wafer and the method for producing the same according to the present invention, even a silicon single crystal substrate with a high resistivity and an ultra-low oxygen concentration, which is extremely promising as a support substrate for a high frequency device, a nitride semiconductor wafer in which plastic deformation and warpage are suppressed can be provided.

### BRIEF DESCRIPTION OF DRAWINGS

FIG. 1 is a schematic cross-sectional view conceptually showing an example of a nitride semiconductor wafer according to the present invention,
FIG. 2 is a schematic cross-sectional view showing a case where a HEMT structure is formed as an application example of the nitride semiconductor wafer according to the present invention,
FIG. 3 is a graph showing changes in curvature of a nitride semiconductor wafer during vapor phase growth.

### DESCRIPTION OF EMBODIMENTS

The present invention will be described in detail below, but the present invention is not limited to these.

As described above, there has been a demand for nitride semiconductor wafers and methods of producing the same of which plastic deformation and warpage are suppressed even when using a silicon single crystal substrate with high resistivity and low oxygen concentration, which is promising as a support substrate for high frequency devices but has low mechanical strength.

Silicon single crystals having the low oxygen concentration, in particular, ultra-low oxygen concentration of less than 1 × 10¹⁷ atoms/cm³, and even 0.5 × 10¹⁷ atoms/cm³ or less, and high resistivity can reliably reduce parasitic capacitance, and improve the high-frequency characteristics of the high-frequency devices. Therefore, such silicon single crystals is highly expected to be applied as semiconductor devices that will be required for high-frequency applications with higher-performance in the future.

However, in case of ultra-low oxygen, the amount of oxygen impurities is particularly low, so the mechanical strength is extremely low, and warpage and plastic deformation are likely to become extremely large during epitaxial growth.

Silicon single crystal substrates for high frequency devices are required to have a high resistivity of 1000 Ω·cm or more. Further, by setting the oxygen concentration to 7 × 10¹⁷ atoms/cm³ or less, particularly less than 1 × 10¹⁷ atoms/cm³, the effect of thermal donors on resistivity can be completely suppressed. However, when the resistivity is high and the oxygen concentration is extremely low, the Young's modulus when dislocations occur is lower than that of a normal low-resistivity substrate, and the substrate is extremely susceptible to plastic deformation. Under this circumstance, the inventors of the present invention have found that plastic deformation can be suppressed by using a silicon single crystal substrate having a wafer thickness of 1000 um or more.

That is, as a result of extensive studies on the above problems, the inventors of the present invention have found by a method for producing a nitride semiconductor wafer in which a nitride semiconductor thin film is grown on a silicon single crystal substrate by vapor phase growth, including, by using a silicon single crystal substrate having a resistivity of 1000 Ω·cm or more, an oxygen concentration of less than 1×10¹⁷ atoms/cm³ and a thickness of 1000 um or more, growing the nitride semiconductor thin film on the silicon single crystal substrate by vapor phase growth, a nitride semiconductor wafer in which plastic deformation and warpage are suppressed even when using a silicon single crystal substrate with a high resistivity and an ultra-low oxygen concentration can be produced and have completed the present invention.

Furthermore, the inventors of the present invention also have found that plastic deformation and warpage are suppressed by a nitride semiconductor wafer having a nitride semiconductor thin film on a silicon single crystal substrate, wherein the silicon single crystal substrate has a resistivity of 1000 Ω·cm or more, an oxygen concentration of less than 1 × 10¹⁷ atoms/cm³, and a thickness of 1000 µm or more.

Description will be made below with reference to the drawings.

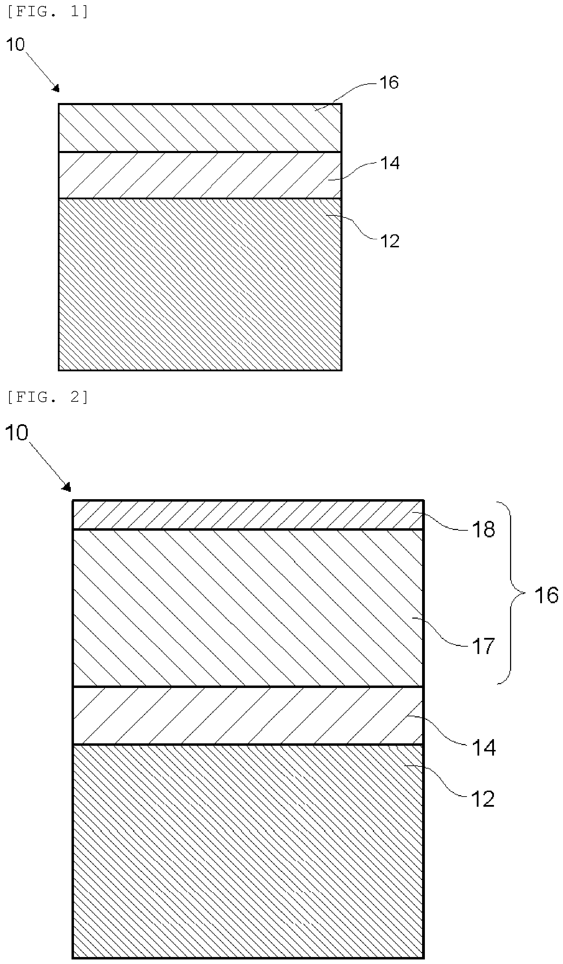

FIG. 1 is a schematic cross-sectional view conceptually showing an example of a nitride semiconductor wafer according to the present invention. A nitride semiconductor wafer 10 according to the present invention shown in FIG. 1 has a device layer 16 made of a nitride semiconductor thin film on a silicon single crystal substrate 12. A silicon single crystal substrate having a resistivity of 1000 Ω·cm or more, an oxygen concentration of less than 1×10¹⁷ atoms/cm³ and a thickness of 1000 um or more is used as the silicon single crystal substrate 12.

The reason why the silicon single crystal substrate has a resistivity of 1000 Ω·cm or more is to achieve a level required as a substrate for high-frequency devices. Since the resistivity of the silicon single crystal substrate is preferable as high as possible, the upper limit is not particularly limited and may be infinite. As for the oxygen concentration, if it exceeds 7×10¹⁷ atoms/cm³ (JEIDA), the influence of thermal donors on resistivity cannot be ignored, so 7×10¹⁷ atoms/cm³ (JEIDA) is set as the upper limit. In addition, in order to completely eliminate the influence of resistivity due to thermal donors, to reliably reduce parasitic capacitance, and improve the high-frequency characteristics of high-frequency devices, and then make the wafer applicable for semiconductor devices which are required for future high-frequency applications with higher performances, an oxygen concentration is set low, in particular, an ultra-low oxygen concentration of less than 1 × 10¹⁷ atoms/cm³, even 0.5 × 10¹⁷ atoms/cm³ or less. This can almost completely eliminate the influence of oxygen concentration. The oxygen concentration is preferable as low as possible, and although the lower limit is not particularly limited, it can be substantially 0 like a FZ single crystal.

On the other hand, by setting the thickness of the silicon single crystal substrate to 1000 µm. or more, it is possible to prevent plastic deformation during growth of the nitride semiconductor and reduce warpage. Although the upper limit of the thickness of the silicon single crystal substrate is not particularly limited, it is preferably about 1500 um or less. If the thickness is within such a range, it is possible to suppress an increase in cost, to perform epitaxial growth of the nitride semiconductor thin film more stably, and to polish the silicon single crystal substrate in a post-process making it thinner as described later, the decrease of productivity can be suppressed.

Further, as shown in FIG. 1, an intermediate layer 14 made of nitride semiconductor, metal, or the like may be provided between the silicon single crystal substrate 12 and the device layer 16. The intermediate layer 14 may act as a buffer layer inserted for improving the crystallinity of the device layer 16 and controlling stress. By having an appropriate buffer layer during nitride semiconductor growth, the stress from the thin film due to the difference in thermal expansion coefficient and lattice constant after cooling can be controlled. At this time, if the intermediate layer 14 is made of a nitride semiconductor, it is desirable that it can be made with the same equipment as the device layer 16. When the intermediate layer 14 is made of a nitride semiconductor, the composition may be different from or the same as the composition of the nitride semiconductor thin film forming the device layer 16. Further, in this case, it can be said that the intermediate layer 14 and the device layer 16 constitute a nitride semiconductor thin film. The composition of the intermediate layer 14 may be changed during the growth. If there is no need to improve stress or crystallinity, the intermediate layer 14 acting as a buffer layer or the like can be omitted. In addition, the intermediate layer 14 may be made of a metal that can be used as a sacrificial layer for creating a space or as an electrode in terms of the structure of a device such as a high-frequency filter.

In addition, a trap-rich layer that reduces the lifetime of carriers may be formed on the surface of the silicon single crystal substrate 12 (the interface with the intermediate layer 14 in FIG. 1).

A device layer 16 made of a nitride semiconductor thin film is provided on the silicon single crystal substrate 12 (on the intermediate layer 14 when the intermediate layer 14 is formed on the silicon single crystal substrate 12). As the nitride semiconductor of the device layer, for example, GaN, AlN, InN, AlGaN, InGaN, AlInN, etc. can be used.

As an application example of the nitride semiconductor wafer according to the present invention, FIG. 2 shows a case where a high electron mobility transistor (HEMT) structure is formed. As shown in FIG. 2, for example, in a high electron mobility transistor (HEMT) structure, the device layer 16 is composed of a gallium nitride (GaN) layer 17 and an electron supply layer 18 made of AlGaN formed thereon. The device layer 16 is desirably a crystal with few crystal defects and few impurities such as carbon and oxygen in order to improve device characteristics.

Gallium nitride (GaN) has lattice constant difference of 17% and thermal expansion coefficient difference of 116% from Si (111) single crystal, and stresses are applied to the thin film and substrate during growth at high temperature. In addition, since the wafer is heated to 1000 °C or higher during growth, when stress is applied to the wafer, it does not undergo brittle fracture but exhibits ductility, generates dislocations, and undergoes plastic deformation.

Therefore, according to the present invention, by using a silicon single crystal substrate 12 having a thickness of 1000 um or more, it is possible to prevent dislocation propagation in the silicon single crystal substrate 12 and prevent plastic deformation. By preventing plastic deformation, abnormal warpage can be reduced, and the yield of producing the nitride semiconductor wafer 10 can be improved. In addition, since the silicon single crystal substrate 12 can withstand stress, the film thickness of the nitride semiconductor thin film that becomes the device layer 16 can be increased by vapor phase growth, and the degree of freedom in designing the device is improved.

Next, a method for producing a nitride semiconductor wafer according to the present invention will be described. Referring to FIG. 1, in the method of producing a nitride semiconductor wafer according to the present invention, first, a silicon single crystal substrate 12 is provided, and then a nitride semiconductor thin film that becomes a device layer 16 is grown on the silicon single crystal substrate 12 by vapor phase growth. In the present invention, a silicon single crystal substrate having a resistivity of 1000 Ω·cm or more, an oxygen concentration of less than 1×10¹⁷ atoms/cm³ and a thickness of 1000 um or more is used as the silicon single crystal substrate 12. Thus, by making the silicon single crystal substrate thicker than 1000 µm, it is possible to prevent plastic deformation during high temperature growth.

A method for producing such a silicon single crystal substrate having a thickness of 1000 um or more is not particularly limited, and it can be produced by a known method. By slicing, polishing, cleaning, etc., a silicon ingot formed by the CZ method or the FZ method, a silicon single crystal substrate having a thickness of 1000 um or more may be produced, or a silicon single crystal substrate having a thickness of 1000 um or more may be formed by forming a silicon epitaxial growth layer on a silicon single crystal substrate having a thickness of less than 1000 µm.

An intermediate layer 14 may be formed on the silicon single crystal substrate 12 before the growth of the nitride semiconductor thin film that becomes the device layer 16, and the nitride semiconductor thin film that becomes the device layer 16 may be grown on the intermediate layer 14.

Furthermore, a trap-rich layer may be formed on the surface of the silicon single crystal substrate 12 (the interface with the intermediate layer 14 in FIG. 1) to reduce the lifetime of carriers. The trap-rich layer can be formed by ion implantation or irradiation with ionizing radiation such as electron beam, X-ray, and γ-ray, but is not limited to these.

On the silicon single crystal substrate 12 (on the intermediate layer 14 when the intermediate layer 14 is formed on the silicon single crystal substrate 12), a device layer 16 made of a nitride semiconductor thin film is produced by vapor phase growth such as MOVPE (metal organic chemical vapor phase epitaxy) method or sputtering method. The nitride semiconductor thin film can be 1-10 um thick and can be designed for the device.

In the high electron mobility transistor (HEMT) structure shown in FIG. 2, the device layer 16 is desirably a crystal layer with few crystal defects and few impurities such as carbon and oxygen in order to improve device characteristics, and can be made at 900°C to 1350°C by using MOVPE method for example.

As described above, plastic deformation during high-temperature growth can be prevented by making the silicon single crystal substrate thicker than 1000 µm. A wafer with small warpage can be obtained, even if after the nitride semiconductor thin film is grown by vapor phase growth, and after cooling, the substrate is thinned to have a suitable thickness for device production by polishing the surface of the silicon single crystal substrate opposite to the surface on which the nitride semiconductor thin film is grown, or the like. In this case, even if the silicon single crystal substrate is thinned, plastic deformation does not occur in the substrate, so that a nitride semiconductor wafer having a device layer on a thinned silicon single crystal substrate without plastic deformation can be obtained.

### EXAMPLE

The present invention will be specifically described below with reference to Examples and Reference Examples, but these are not intended to limit the scope of the present invention.

### (Reference Example 1)

A silicon single crystal substrate having a diameter of 150 mm, an axial orientation of <111>, a resistivity of 1000 Ω·cm, an oxygen concentration of 5 × 10¹⁷ atoms/cm³, and a thickness of 1000 µm was provided. An epitaxial layer of a nitride semiconductor thin film having a total thickness of 2.8 um was grown on the provided silicon single crystal substrate at growth temperature of 1200 °C in a MOVPE furnace.

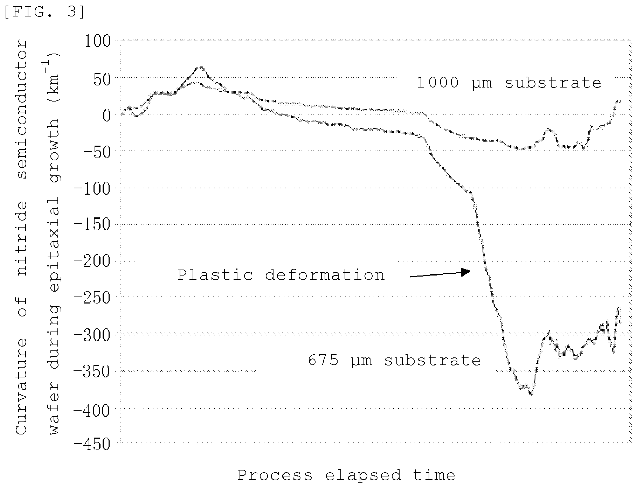

FIG. 3 shows changes in curvature of a nitride semiconductor wafer during epitaxial growth. In Reference Example 1, almost no change in curvature was observed as compared with Reference Example 2, which will be described later. Moreover, no plastic deformation occurred during the epitaxial growth, and the warpage after the growth was 11.3 um. Wafer bow represents the deviation from the reference plane at the center. The sign defines a downwardly convex shape as positive and an upwardly convex shape as negative warpage.

### (Reference Example 2)

A nitride semiconductor wafer was produced under the same conditions as in Reference Example 1, except that thickness of the silicon single crystal substrate was 675 µm.

In Reference Example 2, the curvature changed significantly during the epitaxial growth. Moreover, plastic deformation occurred during the epitaxial growth, and the bow after growth was as large as -233.2 µm, resulting in a failure.

From Reference Examples 1 and 2, it was found that if the thickness of the silicon single crystal substrate 12 with an oxygen concentration of 5×10¹⁷ atoms/cm³ was 1000 um or more, the occurrence of plastic deformation could be suppressed and the warpage could be reduced.

### (Reference Example 3)

A nitride semiconductor was epitaxially grown under the same conditions as in Reference Example 1, except that a thickness of the silicon single crystal substrate was 1200 um, but plastic deformation did not occur in the substrate as in Reference Example 1.

### (Reference Example 4)

A nitride semiconductor wafer was produced under the same conditions as in Reference Example 1, except that an oxygen concentration of the silicon single crystal substrate was 1×10¹⁷ atoms/cm³.

As a result, no plastic deformation occurred during epitaxial growth, and the warpage after growth was 20.0 µm.

### (Example 1)

A nitride semiconductor wafer was produced under the same conditions as in Reference Example 1, except that an oxygen concentration of the silicon single crystal substrate was 0.8 × 10¹⁷ atoms/cm³.

As a result, no plastic deformation occurred during epitaxial growth, and the warpage after growth was 32.0 µm.

### (Example 2)

A nitride semiconductor wafer was produced under the same conditions as in Reference Example 1, except that the silicon single crystal substrate had an oxygen concentration of 0.5×10¹⁷ atoms/cm³ and a thickness of 1200 um.

As a result, no plastic deformation occurred during epitaxial growth, and the warpage after growth was 22.0 µm.

As described above, in the examples, even if the oxygen concentration of the silicon single crystal substrate was set to ultra-low oxygen concentration of less than 1 × 10¹⁷ atoms/cm³, plastic deformation did not occur, and the warpage after growth could be 50 um or less, which was significantly smaller than that of Reference Example 2.

Therefore, the nitride semiconductor wafer of the present invention can be applied to semiconductor devices that is required for feature high-frequency applications with higher-performance.

The present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A method for producing a nitride semiconductor wafer, in which a nitride semiconductor thin film is grown on a silicon single crystal substrate by vapor phase growth, comprising,
by using a silicon single crystal substrate having a resistivity of 1000 Ω·cm or more, an oxygen concentration of less than 1×10¹⁷ atoms/cm³ and a thickness of 1000 um or more, growing the nitride semiconductor thin film on the silicon single crystal substrate by vapor phase growth.

2. The method for producing a nitride semiconductor wafer according to claim 1, wherein after the nitride semiconductor thin film is grown by vapor phase growth, surface of the silicon single crystal substrate opposite to the surface on which the nitride semiconductor thin film is grown is polished to thin the silicon single crystal substrate.

3. A nitride semiconductor wafer having a nitride semiconductor thin film on a silicon single crystal substrate,
wherein the silicon single crystal substrate has a resistivity of 1000 Ω·cm or more, an oxygen concentration of less than 1 × 10¹⁷ atoms/cm³, and a thickness of 1000 µm or more.
